# EUROPEAN PATENT SPECIFICATION

(11) **EP 1 241 209 B1**
(45) Date of publication and mention of the grant of the patent: **07.06.2006**
(21) Application number: 02251594.4
(22) Date of filing: 06.03.2002
(51) Int. Cl.: C08J 7/02, C09K 13/00, C23C 18/26

(54) **Solvent swell composition containing heterocyclic nitrogen compounds and glycols for texturing resinous material and desmearing and removing resinous material**
Quelllösung enthaltend heterocyclische Stickstoffverbindungen und Glykole zur Texturierung und Säuberung von Polymeroberflächen
Solvant gonflant contenant des composés hétérocycliques contenant du nitrogène et des glycols pour la texturation et le décapage et l'ébeurrage de surfaces polymériques

(30) Priority: 08.03.2001 GB 0105718
(43) Date of publication of application: 18.09.2002
(73) Proprietor: Shipley Co. L.L.C., Marlborough, MA 01752 (US)
(72) Inventor: Graves, John E., Nuneaton, Warwickshire CV11 6YT (GB); Chohan, Varinder, Coventry CV6 7DA (GB); Hirst, Deborah V., Nuneaton, Warwickshire CV11 4FS (GB); Poole, Mark A., Warwickshire CV22 7EA (GB)
(74) Representative: Kent, Venetia Katherine

(56) References cited:
- US-A- 4 401 747
- US-A- 4 401 748
- PATENT ABSTRACTS OF JAPAN vol. 1999, no. 13, 30 November 1999 (1999-11-30) & JP 11 209754 A (HITACHI CHEM CO LTD), 3 August 1999 (1999-08-03)
- PATENT ABSTRACTS OF JAPAN vol. 1999, no. 12, 29 October 1999 (1999-10-29) & JP 11 193380 A (HITACHI CHEM CO LTD), 21 July 1999 (1999-07-21)

## Description

### Background of the Invention

The present invention is directed to a composition containing heterocyclic nitrogen compounds in combination with glycols that may be used as a solvent swell. More specifically, the present invention is directed to a composition containing heterocyclic nitrogen compounds in combination with glycols that may be used as a solvent swell to condition resinous material for porous texturing as well as desmearing and removing resinous material from a substrate.

Coating or plating a nonconductive substrate with a continuous metal coating or patterned or discontinuous metal coating or plating has been employed in a number of industries and applications for many years. Such substrates are often composite substrates composed of a resin sheet having a thin metal foil laminated or clad to both sides of the resin sheet leaving the nonconductive plastic sandwiched between the two metal surfaces. Holes are often drilled through the metal clad and the resin exposing the resin where the holes are drilled. The composite substrates, after being metal plated, may be used to produce printed circuit boards for electrical or electronic applications.

Hole forming operations in resin containing materials often result in the smearing of resin over the interior wall or barrel of the hole. This resin smear is primarily attributable to the generation or utilization of temperatures exceeding those at which resinous components decompose during the hole forming process.

Where holes are drilled in epoxy impregnated fiberglass laminate materials, such as those employed to make printed circuit boards, friction of the drill bit against the material raises the temperature of the bit. Often drill bit temperatures are generated which exceed the decomposition temperature of many resin systems. The drill bit thus picks up resinous components on its course through the material being drilled, and this resinous accretion is smeared in the barrel of the hole. In laser drilling operations, to contact interior conductors in organic insulating substrates, a similar resinous accretion or smear can develop on the exposed conductor surface.

While the problem of resin smear on hole walls may be ignored in some applications, it is at times imperative that it be removed such as in the manufacture of printed circuit boards. Printed circuit boards are used for a variety of electrical applications and provide the advantage of conservation of weight and space. A printed circuit board comprises one or more circuit layers, each circuit layer separated from another by one or more layers of dielectric material. Circuit layers are formed by patterning a copper layer on the polymeric substrate. Printed circuits are then formed on the copper layers by techniques well known to the art, for example print and etch to define and produce the circuit traces, that is, discrete circuit lines in a desired circuit pattern. Once the circuit patterns are formed, a stack is formed comprising multiple circuit layers separated from each other by a dielectric layer, typically a resin-containing material such as epoxy, epoxy/glass or polyimide. Once the stack is formed, it is subjected to heat and pressure to form the laminated multilayer circuit board. When such a multilayer circuit board is made, holes are formed in the resin-containing material that includes a plurality of parallel planar metallic conductors, with the hole perpendicular to, and communicating with, two or more parallel metallic conductors. Often the hole walls are metallized in order to form a conductive path between two or more of the metallic conductors. In such instances, the resin smear must be removed from the hole walls through the metallic conductors if conductive contact between the metallized hole wall and the metallic conductors is to be achieved. Thus, when circuit board holes are drilled through a copper clad base polymeric substrate or through a laminate containing internal conductor planes such as in a multilayer circuit board, resin smear on the metallic surfaces exposed to the walls of the holes must be removed to achieve proper functioning of the metallized, or plated through-holes.

Plated through-holes, as described above, are useful as electrical connections between printed circuits having metallic conductors on both sides of the resinous or plastic laminate or between two or more of the various planes and surface conductor layers in multilayer boards. The electrical and mechanical integrity required for this function can only be attained by insuring complete removal of resinous materials from the entire inner circumference of the portion of the metallic conductor exposed by the hole.

Numerous methods are known for removing resin smear. For example, plasma is widely used which removes resinous components by vapourisation. Another approach is a mechanical one and involves channeling a dry or wet stream of abrasive particles through such holes. A similar method uses hydraulic pressure to force a thick slurry of abrasive material through the holes. However, these mechanical methods are slow and difficult to control and complete removal of smear in all holes in a given circuit board is difficult to achieve.

Chemical methods are used to desmear holes formed during printed circuit board manufacture. The most common chemical method is treatment with a permanganate solution, such as potassium or sodium permanganate. In general, such permanganate solutions are alkaline.

Permanganate treatment is also used to texturize or micro-roughen the surface of resinous material, such as dielectrics used in printed wiring board manufacture. While not intending to be bound by theory, such textured surfaces are thought to improve metal, particularly copper, adhesion to the resinous material. Resinous materials show a relatively poor affinity for metal and to promote a stronger bond between a resinous substrate and a metallic coating the art has frequently resorted to micro-roughening or texturing the resinous surface to provide locking or keying between the surface and a metal coating. Thus, texturing resinous material with permanganate treatment is important in obtaining a metal coating on the resinous material.

Permanganate treatment involves three different treatment solutions used sequentially. They are (1) a solvent swell solution, (2) a permanganate desmear solution, and (3) a neutralization solution. A printed wiring board is dipped or otherwise exposed to each solution with water rinse baths employed between each of these three treatment solutions.

The solvent swell solution or composition typically contains an organic solvent or a mixture of solvents which renders the resinous material more amenable to removal by the permanganate. Such solvent swell compositions are generally alkaline. For example, European Patent Application EP 454 929 (Retallick et al.) discloses a method for improving the adhesion of metal to a polyimide substrate by first contacting the substrate with a composition of water, butyl carbitol, ethylene glycol and sodium hydroxide, i.e. solvent swell, followed by contact with an aqueous alkaline permanganate solution.

U.S. Patent No. 5,985,040 (Carano et al.) discloses a permanganate texturizing step in the manufacture of printed wiring boards using a solvent swell composition of from about 10% to about 30% by volume of gamma butyrolactone and from about 70% to about 90% by volume of heterocyclic nitrogen compound N-methyl-2-pyrrolidone.

U.S. Patent No. 5,015,339 (Pendleton) discloses a permanganate texturizing step in the manufacture of printed wiring boards. In the '339 patent, a solvent swell step using a composition containing an alkali metal hydroxide and glycol ether or other solvent, such as N-methylpyrrolidone ("NMP"), is disclosed. The preferred combination is an alkali metal hydroxide and a glycol ether mixture.

U.S. Patent No. 4,086,128 (Sugio et al.) discloses a variety of solvents for swelling resinous materials prior to a hydrogen peroxide and sulfuric acid etch step. Such solvents include alcohols, acids and acetates.

Commercially available non-aqueous 100% solvent swell compositions containing a mixture of NMP and ethylene glycol butyl ether provide good texturing on conventional FR-4 type materials that have a Tg of about 135° C. However, at standard operating temperatures resin desmear is poor with high Tg materials. Also, such formulations have low flash points of about 60° C and preferably are not employed in operations where temperatures exceed about 50° C.

In an effort to increase manufacturing throughput, particularly of printed wiring boards, ways have been sought to decrease the number of process steps, time of each process step or both. Reducing the time of each process step is especially important for horizontal methods of making printed circuit boards as opposed to vertical methods. Horizontal methods are more expensive than vertical methods because of the use of costly equipment. Thus solvent swell and permanganate dwell times on the resin material are shorter in horizontal methods than in vertical methods. The solvent swell and permanganate must effectively desmear and texturize the resin within a short time period, i.e., less than about 60 minutes for a vertical process and less than about 15 minutes for a horizontal process. Also, many resin materials that are highly desirable in the manufacture of printed circuit boards have high Tg values such as from about 150° C to about 180° C or greater and are chemically resistant to many solvent swell and texturing compositions. Such high Tg resins are particularly suitable for use in sequential build up ("SBU") applications. Thus there is a need for solvent swell techniques that are effective in increasing the removal or etching rate of resinous material and that enable more thorough removal of resinous material.

As mentioned above texturing improves the adhesion between a resin material and a metal coating. Poor adhesion between resins and the metal coating allows differential dimensional changes with temperature that may result in warping, blistering, and cracking of the metallized product. Consequently, strong adhesion between a resin substrate and the metal layer is essential for any application in which the product is subjected to significant temperature fluctuations. More importantly, the strong adhesion between resins and metal layers is such that de-lamination does not occur during use of the product. Thus, the life of the product is prolonged.

Accordingly, there is a need for solvent swell techniques that desmear resin rapidly, and that are effective in substantially increasing the texturing of resinous material to improve adhesion between a resinous material and a metal layer.

### Summary of the Invention

The present invention in its various aspects in as set out in the accompanying claims. The present invention is directed to a solvent swell composition containing a heterocyclic nitrogen compound in combination with a glycol and a method of using the composition to treat a resinous substrate such that the solvent swell conditions the resinous substrate for texturing or micro-roughening with an etchant. In addition to a heterocyclic nitrogen compound and a glycol, the solvent swells of the present invention may also contain water, a high flash point solvent or mixtures thereof.

Advantageously, the heterocyclic nitrogen compound and glycol containing solvent swell compositions contain a heterocyclic nitrogen compound and glycol in sufficient amounts to condition a resinous substrate such that contacting the conditioned resinous substrate with an etchant provides porous texturing of the resinous substrate. The porous resinous substrate provides a mechanical means by which a deposited metal may anchor onto the resinous surface to form a high integrity bond with the resin. Such a high integrity bond prevents warping, blistering and cracking of the metallized substrate. Also, the metal resin bond does not readily de-laminate.

Additionally, the heterocyclic nitrogen compound and glycol containing solvent swell compositions and methods of the present invention provide effective desmearing and removal of resinous material from a substrate. The present invention is particularly effective for use with resinous material that is used in the manufacture of printed wiring boards.

Advantageously, the solvent swell compositions and methods may be effectively employed in both horizontal and vertical methods of manufacturing printed circuit boards. The solvent swell compositions may be employed over short dwell times, thus providing highly suitable solvent swell compositions and methods for horizontal circuit board manufacturing methods. Also, the solvent swell compositions and methods may be effectively used to texture and desmear both high and low Tg resins.

A primary objective of the present invention is to provide a composition containing a heterocyclic nitrogen compound in combination with a glycol that conditions a resinous material such that the resinous material is porously textured with an etchant.

Another objective of the present invention is to provide a composition containing a heterocyclic nitrogen compound in combination with a glycol that removes resinous material from a substrate.

An additional objective of the present invention is to provide a solvent swell composition that textures and desmears resin over short dwell times.

A further objective of the present invention is to provide a method for porous texturing resinous material of a substrate including the steps of first contacting the resinous material with a composition including a heterocyclic nitrogen compound in combination with a glycol; and then contacting the resinous material with an etching composition.

Yet another objective of the present invention is to provide a method for desmearing resin from the inside walls of holes formed in resinous substrates including the steps of first contacting the resinous substrate with a composition including a heterocyclic nitrogen compound in combination with a glycol; and then contacting the resinous substrate with an etching composition.

Additional advantages and objectives may be ascertained by those of skill in the art after reading the following detailed description and the appended claims.

### Brief Description of the Drawings

Figs. 1A-B are electron micrographs taken at 2000X of a Isola E117 resin material (1A) and a Polyclad® 370 resin material (1B) treated with a solvent swell containing 10% bv of N-methyl-2-pyrrolidone with the balance water;
Figs. 2A-B are electron micrographs taken at 2000X of a Isola E117 resin material (2A) and a Polyclad® 370 resin material (2B) treated with a solvent swell containing 20% bv of N-methyl-2-pyrrolidone with the balance water;
Figs. 3A-B are electron micrographs taken at 2000X of a Isola E117 resin material (3A) and a Polyclad® 370 resin material (3B) treated with a solvent swell containing 30% bv of N-methyl-2-pyrrolidone and the balance water;
Figs. 4A-B are electron micrographs taken at 2000X of a Isola E117 resin material (4A) and a Polyclad® 370 resin material (4B) treated with a solvent swell containing 40% bv N-methyl-2-pyrrolidone and the balance water;
Figs. 5A-B are electron micrographs taken at 2000X of a Isola E117 resin material (5A) and a Polyclad® 370 resin material (5B) treated with a solvent swell containing 50% bv of N-methyl-2-pyrrolidone and the balance water;
Fig. 6 is an electron micrograph taken at 2000X of a Isola E117 resin material treated with a solvent swell of 100% bv of diethylene glycol monobutyl ether;
Figs. 7A-B are electron micrographs taken at 2000X of a Isola E117 resin material (7A) and a Polyclad® 370 resin material (7B) treated with standard desmear chemistry;
Figs. 8A-C are electron micrographs taken at 2000X of a Isola E104 resin material (8A), a Isola E117 resin material (8B), a Polyclad® 370 resin material (8C) treated with a solvent swell containing 40% bv ethylene glycol monophenyl ether/40% bv N-methyl-2-pyrrolidone and the balance water;
Figs. 9A-D are electron micrographs taken at 2000X of a Isola E104 resin material (9A), a Isola E117 resin material (9B), a Nelco® 4000-6 resin material (9C) and a Polyclad® 370 resin material (9D) treated with a solvent swell containing 10% bv ethylene glycol monophenyl ether/20% bv N-methyl-2-pyrrolidone and the balance water;
Figs. 10A-D are electron micrographs taken at 2000X of a Isola E104 resin material (10A), a Isola E117 resin material (10B), a Nelco® 4000-6 resin material (10C), and a Polyclad® 370 resin material (10D) treated with a solvent swell containing 20% bv ethylene glycol monophenyl ether/20% bv N-methyl-2-pyrrolidone with the balance water;
Figs. 11A-D are electron micrographs taken at 2000X of Isola E104 resin material (11A), a Isola E117 resin material (11 B), a Nelco® 4000-6 resin material (11C), and a Polyclad® 370 resin material (11D) treated with a solvent swell containing 20% bv ethylene glycol monophenyl ether/40% bv N-methyl-2-pyrrolidone with the balance water; and
Figs. 12A-D are electron micrographs taken at 2000X of a Isola E104 resin material (12A), a Isola E117 resin material (12B), a Nelco® 4000-6 resin material (12C), and a Polyclad® 370 resin material (12D) treated with a solvent swell containing 40% bv ethylene glycol monophenyl ether/20% bv N-methyl-2-pyrrolidone solution.

### Detailed Description of the Invention

As used throughout this specification, the abbreviations given below have the following meanings, unless the context clearly indicates otherwise: g = gram; mg = milligram; cm = centimeter; DI = deionized; ° C = degrees Centigrade; M = molar; g/l = grams per liter; bv = by volume; wt% = percent by weight; and Tg = glass transition temperature.

The terms "printed circuit board" and "printed wiring board" are used interchangeably throughout this specification. The term "alkyl" or "alkane" refers to linear, branched or cyclic alkyl or alkane. Likewise, the term "alkenyl" or "alkene" refers to linear, branched or cyclic alkenyl or alkene. All amounts are percent by volume, unless otherwise noted. All numerical ranges are inclusive and are combinable.

The solvent swell compositions of the present invention include a heterocyclic nitrogen compound in combination with a glycol. The solvent swell compositions are employed to condition or treat a resinous material such that the resinous material becomes substantially textured or micro-roughened when the conditioned or treated resinous material is etched. The solvent swell compositions that may be employed include heterocyclic nitrogen compound in combination with a glycol in sufficient quantities to condition a resinous material such that upon etching the conditioned resinous material a porous texture is formed thereon. Porous, as defined within the scope of the present invention, means a state of a solid body penetrated by minute open spaces filled with a liquid or a gas. Porosity (P) may be expressed as the percentage of open space in the total volume. The heterocyclic nitrogen compound and glycol solvent swell of the present invention provides a porosity of at least about 60%. Preferably the present invention provides a porosity of at least about 75%, most preferably from about 85% to about 95%. Also, the present invention may employ heterocyclic nitrogen compounds in combination with glycols in sufficient quantities to condition resinous material for desmearing and removing the resinous material from a substrate.

The heterocyclic nitrogen compounds of the present invention that may condition a resinous material for porous texturing and/or desmearing resinous material from a substrate are limited to, five-membered ring pyrrolidones and five-membered ring pyrrolidines. Examples of such pyrrolidones include N-methyl-2-pyrrolidone, 2-pyrrolidone, N-ethyl-2-pyrrolidone, N-cyclohexyl 2 pyrrolidone, N-dodecyl-2-pyrrolidone, N-(2-hydroxyethyl)-2-pyrrolidone, 1,5-dimethyl-2-pyrrolidone, 3,3-dimethyl-2-pyrrolidone, and the like. Examples of such pyrrolidines include pyrrolidine, 1,2-dimethyl pyrrolidine, 2,5-dimethyl pyrrolidine, and the like. Solvent swells of the present invention may contain mixtures of the above disclosed heterocyclic nitrogen compounds. The pyrrolidone compounds are preferred over the pyrrolidines. The most preferred are the compounds N-methyl-2-pyrrolidone and N-(2-hydroxyethyl)-2-pyrrolidone. N-(2-hydroxyethyl)-2-pyrrolidone is especially preferred because N-(2-hydroxyethyl)-2-pyrrolidone has a high flash point of about 174° C and does not present a flammable hazard during circuit board manufacture. Other suitable high flash point solvents that may be employed to practice the present invention are disclosed below.

Glycols that are employed in solvent swells of the present invention are the glycol phenyl ethers. The most prefered are ethylene glycol monophenyl ether, ethylene glycol diphenyl ether, propylene glycol monophenyl ether, propylene glycol diphenyl ether and dipropylene glycol monophenyl ether. Ethylene glycol monophenyl ether and propylene glycol monophenyl ether are especially preferred because of their high flash points of about 121° C and about 120° C, respectively. Solvent swells of the present invention may contain mixtures of the above-disclosed glycols.

Although many glycol phenyl ethers are liquids at room temperature, they do not solubilize well in aqueous solutions or many organic solvents employed in solvent swell compositions. Advantageously, heterocyclic nitrogen compounds of the present invention readily solubilize glycol phenyl ethers such that the solvent swell properties of the glycol phenyl ethers may be optimized. Preferred heterocyclic nitrogen compounds that readily solubilize many of the glycol phenyl ethers are the pyrrolidone compounds. Particularly preferred pyrrolidones for solubilizing glycol phenyl ethers are N-methyl-2-pyrrolidone and N-(2-hydroxyethyl)-2-pyrrolidone.

In addition to the heterocyclic nitrogen compounds and the glycols defined, the compositions of the present invention may include high flash point solvents, examples of which are disclosed above. High flash point solvents within the scope of the present invention have a flash point (F.p.) of at least about 100° C. Preferably, flash points of high flash point solvents within the scope of the present invention range from about 120° C to about 180° C. Examples of suitable high flash point solvents include, but are not limited to, alkylene - carbonates such as ethylene carbonate (F.p.= about 160° C), propylene carbonate (F.p.= about 132° C), and the like. High flash point solvents are highly desirable in solvent swell' compositions because such solvents do not present a flammable hazard during circuit board manufacture. Thus high flash point solvents may be included in solvent swells containing heterocyclic compounds with glycols in sufficient amounts to deter a flammable hazard during circuit board manufacture. Preferably, high flash point solvents may be employed in the solvent swells in amounts of from about 2% bv to about 45% bv, more preferably from about 10% bv to about 30% bv, most preferably from about 15% bv to about 25% bv. Many of such high flash point solvents are commercially available and may be used without further purification.

Components of the solvent swell compositions of the present invention are included in sufficient quantities to condition a resinous material for porous texturing and/or desmear a resinous material from a substrate. Heterocyclic nitrogen compounds may compose from about 5% bv to about 99% bv of the solvent swell, and glycols may compose from about 1% bv to about 95% bv of the solvent swell. Preferably, heterocyclic nitrogen compounds may compose from about 15% bv to about 85% bv of the solvent swell. More preferably, the heterocyclic nitrogen compounds defined compose from about 20% by to about 70% bv, most preferably from about 30% bv to about 50% bv of a solvent swell. Preferably the glycol phenyl ethers, compose from about 15% bv to about 85% bv of the solvent swell. More preferably, the glycol phenyl ethers, compose from about 20% bv to about 80% bv, most preferably from about 50% bv to about 70% bv of the solvent swell. When the solvent swell does not compose 100% bv of a heterocyclic nitrogen compound in combination with a glycol, the balance of the solvent swell includes water and/or one or more high flash point solvents. In addition to the water and/or one or more high flash point solvents, an optional wetting agent may be employed as discussed below. When a glycol alkyl ether is employed in the solvent swell, in addition to the heterocyclic nitrogen compound, water and/or a high flash point solvent is added. A preferred solvent swell contains from about 20% bv to about 40% bv of a pyrrolidone compound in combination with from about 10% bv to about 40% bv of a glycol, especially a glycol phenyl ether, with the balance water and/or a high flash point solvent. Particularly preferred solvent swell compositions contain from about 30% bv to about 40% bv of N-methyl-2-pyrrolidone or N-(2-hydroxyethyl)-2-pyrrolidone in combination with from about 30% bv to about 40% bv of ethylene glycol monophenyl ether or propylene glycol monophenyl ether with the balance water and/or a high flash point solvent.

The solvent swell compositions of the present invention may optionally include one or more wetting agents. Suitable wetting agents include, but are not limited to, anionic, cationic and nonionic surfactants, and preferably cationic and nonionic surfactants. When such wetting agents are used, they may be present in an amount from about 0.1 to about 10 wt%. Specific amounts of a surfactant may readily be determined by a person of skill in the art with minimal experimentation. Preferably, such wetting agents are not included in the solvent swell compositions

The components of the solvent swell compositions of the present invention may be mixed together by any suitable method or mixing apparatus known in the art. One or more of the defined heterocyclic nitrogen compounds may be mixed with one or more of the glycols and water or a high flash point solvent. If the desired combination is not miscible, a wetting agent may be added in sufficient quantity to disperse the components of the solvent swell.

The compositions of the present invention may be used to swell a variety of resinous materials prior to a subsequent resin-removal step, such as epoxy resins, other thermosetting resins, thermoplastic resins and mixtures thereof. The resins may also include reinforcing materials, such as organic and inorganic fibres or woven fibre cloths. The compositions of the present invention may be employed to swell conventional resin. Preferably, the compositions of the present invention are employed to swell high Tg resins. By "high Tg resin" it is meant that the glass transition temperature of the resin is about 150° C or greater. Such high Tg resins are particularly suitable for use in sequential build up ("SBU") applications.

Depending upon the particular use and processing conditions chosen, a wide range of resins may be swollen according to the present invention. The present invention is particularly suitable for swelling resinous materials used in printed wiring board manufacture such as FR-4 boards. Suitable resins include, but are not limited to, epoxy resins such as difunctional and multifunctional epoxy resins, polyimide resins, cyanate ester resins, bismaleimide triazine ("BT") resins, resin coated copper ("RCC") type materials, epoxy/polyphenylene oxide resins, and the like, as well as composites thereof. The present invention may also be useful in swelling other resins such as, but not limited to acrylonitrilebutadienestyrene, polycarbonates ("PC"), polyphenylene oxides ("PPO"), polyphenylene ethers ("PPE"), polyphenylene sulfides ("PPS"), polysulfones ("PS"), polyamides, polyesters such as polyethyleneterephthalate ("PET") and polybutyleneterephthalate ("PBT"), polyetheretherketones ("PEEK"), liquid crystal polymers, polyurethanes, polyetherimides, and composites thereof.

The resinous material may be disposed on a substrate, such as a printed wiring board or an inner layer for a printed wiring board. The resinous material is then contacted with the solvent swell of the present invention. Such contact may be by any means, such as dipping the resinous material or a substrate containing the resinous material in a vessel containing the present solvent swell or by spraying the present solvent swell on the resinous material, or by a combination of dipping and spraying. The present invention may be advantageously used in either vertical or horizontal systems.

The resinous material may be contacted with the present compositions for a period of time up to about 30 minutes. The actual period of time depends upon the particular resin, the heterocyclic nitrogen compound and glycol used, any additional components, such as water or high flash point solvents, in the composition, the temperature of the composition, the amount of resinous material to be textured or removed, the processing system, i.e., horizontal or vertical, and the like. Preferably, the period of time is from about 30 seconds to about 30 minutes, more preferably from about 90 seconds to about 10 minutes. The solvent swell compositions of the present invention may be used at a wide variety of temperatures. The actual temperature used depends upon the particular components employed in the solvent swell and the concentrations of such components. The present compositions may be used at from about 20° to about 95° C, and preferably from about 25° to about 85° C.

Once the resinous material is contacted with the solvent swell compositions of the present invention for a period of time sufficient to swell the resinous material and condition the resinous material for texturing, the resinous material is removed from contact with the composition. The resinous material may then optionally be rinsed, and preferably is rinsed, with water.

The conditioned resinous material may then be textured by etching. Any conventional etching composition may be used. Preferably, the conditioned resinous material is textured by etching with a permanganate composition. Such permanganate etching compositions are well known to those skilled in the art. Such permanganate compositions include one or more sources of permanganate ion, one or more hydroxide ion sources and water. Suitable permanganate ion sources include, but are not limited to, sodium permanganate, potassium permanganate and the like. The concentration of permanganate may be in the range of from about 20 to about 150 g/l.

Any alkali metal hydroxide or alkaline earth hydroxide may be used in the permanganate etching compositions as the hydroxide ion source. Preferably the hydroxide ion source is an alkali metal hydroxide. Suitable alkali metal hydroxides include lithium hydroxide, sodium hydroxide, potassium hydroxide, rubidium hydroxide, and cesium hydroxide. It is preferred that the hydroxide ion source is sodium hydroxide or potassium hydroxide. Mixtures of hydroxide ion sources may also be used. Hydroxide ion sources are used in the compositions of the present invention in an amount such that the pH of the permanganate etching composition has a pH of about 12-14.

Once the resinous material is contacted with the permanganate etching composition, the resinous material may then be rinsed with water and then neutralized, such as with dilute acid/hydrogen peroxide.

The compositions of the present invention also are useful in conditioning resin, such as resin smear, for removal from resinous substrates with an etchant. In particular, the present invention is useful to prepare resinous substrates for metallization, for desmearing resin from the inside walls of holes in resinous substrates, for hole cleaning processes for multilayer circuit boards and for etchback processes for circuit boards. Preferably the substrate is a printed wiring board. Preferably the printed wiring board includes one or more layers including epoxy resin, glass/epoxy resin, polyimide resins, cyanate ester resins, bismaleimide triazine ("BT") resins, resin coated copper ("RCC") type materials and composites thereof.

Substrates containing resin to be textured and/or removed, such as resin smear, may be processed by any conventional means using the compositions and methods of the present invention. For example, in the manufacture of a printed wiring board ("PWB"), the following steps may be employed:
1. The PWB is contacted with a solvent swell composition of the present invention before etching. Such solvent swell conditions the resin for texturing, removes oils or dirt, helps uniformly wet the substrate surfaces, both resin and metal, and permeates and softens the resin slightly which helps the permanganate attack of the resin. In an alternative embodiment, the present solvent swell compositions may be sonicated by any means known in the art.
2. The cleaned PWB is then optionally rinsed to remove the cleaning solution.
3. The rinsed PWB is then contacted with the permanganate etching compositions for a time sufficient to effect the desired resin texturing and/or removal. The actual conditions employed will vary with the type of etching desired, for example, texturing and desmearing may require only a short period of time while etchback may require a longer period of time. Suitable times for texturing and/or desmearing are from about 30 seconds to about 30 minutes, more preferably from about 90 seconds to about 10 minutes. In an alternative embodiment, the permanganate etching compositions may be sonicated by any means known in the art.
4. Following permanganate etching, the PWB is thoroughly rinsed.
5. The rinsed PWB is then contacted with an acid neutralization solution, such as dilute sulfuric acid and hydrogen peroxide, to remove substantially all of the permanganate and manganese residues from the board.
6. After acid neutralization, the PWB is again rinsed. The PWB is then ready for subsequent metallization.

Metallization of the PWB may be performed by any suitable method in the art. Suitable methods include, but are not limited to, electroless plating or direct plating of the PWB. Often the PWB contains both a resinous component as well as a metal cladding component. The metal cladding may be copper, nickel or any other suitable metal employed as circuitry. Advantageously, the porous textured surface of the resinous material of the PWB provides an anchoring structure for deposited metal to grasp onto. Such a mechanical means for retaining deposited metal on the resin material improves adhesion between the metal and the resinous material of the PWB. Accordingly, de-lamination of electroplate, especially from resin in through-hole walls, is eliminated or significantly reduced during the life of the electronic devices in which the PWB is employed. De-lamination of electroplate from resin in through-hole walls leads to interconnect defects. Also, warping, blistering and cracking of the metallized product is reduced or prevented.

When electroless plating is performed, the porous textured resin material of the PWB is made electrically conductive by employing an activator. Such activators may be colloidal catalysts of noble or non-noble metals. Many commercial activators contain one or more of the noble metals (Au, Ag, Pt, Pd, Ir, Rh, Ru, and Os). Particularly preferred noble metals are Pd, Pt, Ag, and Au. The most preferred is palladium. Often the palladium is employed as a tin-palladium colloid. Suitable non-noble metals include, but are not limited to, Cu and Ni. The preferred non-noble metal is copper. Often the copper is employed in the colloidal catalyst as a copper oxide.

Advantageously, when the noble and non-noble metal colloidal catalysts are applied to the textured resinous material, the colloidal particles become entrapped within the pores of the surface as well as settling on the top of the textured resinous surface. The colloidal catalyst particles dispersed throughout the porous textured resinous material act as seeds for metal to deposit in the pores and on the surface of the resin. Such a metal layer is continuous across the resin surface and well anchored through the pores of the textured resinous surface to form a metal layer to resin surface bond of high integrity.

The heterocyclic nitrogen and glycol solvent swell composition and method of the present invention may be used to prepare a resinous substrate for any electroless plating method employed in the art. An example of one method of electroless plating is a process according to the following sequence of steps:
1. Contacting a metal clad, epoxy resin PWB that has been textured according to the heterocyclic nitrogen and glycol solvent swell etching and neutraliser method of the present invention.
2. Rinsing the PWB with water for about 4 minutes.
3. Treating the PWB with a sensitizer to optimize catalyst pick-up.
4. Rinsing the PWB with water for about 4 minutes.
5. Etching the metal clad laminate in a microetch for about two minutes.
6. Rinsing the PWB with water for about 4 minutes.
7. Treating the PWB with a pre-dip solution for about 1 minute.
8. Treating the PWB with a tin/palladium catalyst for about 4 minutes.
9. Rinsing the PWB with water for about 4 minutes.
10. Electrolessly depositing metal on the metal cladding and textured resinous material of the PWB.
11. Directly plating metal on the electrolessly deposited metal coated PWB.

Accelerators are optional and are employed to increase or optimize the catalytic activity of the activator in plating metal from the bath that provides the source of the metal in electroless plating. Any accelerator employed in the art may be used. An example of a preferred accelerator is the fluoroborate based accelerator. Suitable baths that provide the source of metal in electroless plating are any bath that is employed in the electroless plating art. The types and amounts of components in such baths vary extensively. For example, an aqueous bath for electroless copper deposition may contain from about 5.0% to about 25% by weight of copper sulfate, a complexing agent such as EDTA (ethylenediamine tetraacetic acid) from about 20 to about 40 g/l, a reducing agent such as formaldehyde from about 0.5 to about 8 g/l and sodium hydroxide from about 3 to about 15 g/l.

While the present invention has been described with respect to printed wiring board processes, it is appreciated by those skilled in the art that the present invention may also be applied to a wide variety of resinous substrates that may be used in a wide variety of applications where swelling of the resin is desired.

As mentioned above an advantage of the present invention is that resinous material is textured such that a metal layer may be deposited on the resinous material forming a mechanical bond of high integrity between the metal and resin. The adhesion between the resin and the metal is such that the metal does not readily separate from the resin. Thus, the present invention is particularly suited to applications where porous texturing of a resin is desired.

Surprisingly, resin removal rate can be controlled by adjusting concentrations of heterocyclic nitrogen and glycol compounds in the solvent swell compositions. Increasing the amount of heterocyclic nitrogen and/or glycol increases the amount of resin removed from a substrate for a given period of time. Thus, the present invention provides a method for controlling the rate of resin removal from a substrate using a composition including one or more heterocyclic nitrogen compounds and/or glycols.

The following example is intended to illustrate further various aspects of the present invention, but is not intended to limit the scope of the invention in any aspect.

### Example

The following comparative tests showed that heterocyclic nitrogen and glycol solvent swell compositions of the present invention conditioned resinous materials for texturing with an etchant such that a high integrity bond may be formed between the resin and deposited metal. Also, the tests showed that the heterocyclic nitrogen and glycol solvent swell compositions of the present invention reduced resin weight, and are suitable for desmearing procedures during PWB preparation.

Solvent swells of the present invention that were used were composed of 40% bv ethylene glycol monophenyl ether and 40% bv N-methyl-2-pyrrolidone (NMP), 10% bv ethylene glycol monophenyl ether and 20% bv N-methyl-2-pyrrolidone (NMP), 20% bv ethylene glycol monophenyl ether and 20% bv N-methyl-2-pyrrolidone (NMP), 20% bv ethylene glycol monophenyl ether and 40% bv N-methyl-2-pyrrolidone (NMP), and 40% bv ethylene glycol monophenyl ether and 20% bv N-methyl-2-pyrrolidone (NMP). The balance of the compositions was water to bring each solvent swell composition to about 100% bv.

Eight control solvent swell compositions were employed. A first control solvent swell (standard desmear formulation) contained diethylene glycol monobutyl ether, sodium hydroxide and a wetting agent. A second control solvent swell (standard desmear formulation) contained diethylene glycol monobutyl ether, triethylene glycol monomethyl ether, sodium hydroxide and a wetting agent. A third control composition contained 100% bv of diethylene glycol monobutyl ether. The remaining five control solvent swells contained 10% bv, 20% bv, 30% bv, 40% bv and 50% bv of NMP with the balance water.

Four types of resinous materials were employed to test the heterocyclic nitrogen and glycol solvent swell compositions of the present invention for their ability to swell, and condition for texturing resinous material. One resinous material employed was Duraver®-E-Cu quality 117 epoxy base material (obtainable from Isola Laminate Systems Corp., La Crosse, WI, U.S.A.) and a second was Polyclad® 370 epoxy base material (obtainable from Polyclad Laminates, Inc., Franklin, NH, U.S.A). Also a standard Duraver®-E-Cu quality 104, FR-4 epoxy/glass material (obtainable from Isola Laminate Systems Corp., LaCrosse, WI, U.S.A.) and Nelco® 4000-6 high Tg multifunctional epoxy laminate. The Duraver®-E-Cu quality 117 epoxy base material (Isola E117) had a Tg of about 170° C. The Duraver®-E-Cu quality 104 (Isola E104) had a Tg of about 135° C (low Tg material, i.e., below 150° C). The Polyclad® 370 had a Tg of about 175° C and the Nelco® 4000-6 had a Tg of about 180° C.

The solvent swell compositions of the present invention were tested for solvent swell conditioning ability of resin material for removal of the resin with etchant. The conditioning ability of the solvent swell compositions of the present invention were contrasted with control solvent swell 1, control solvent swell 2, and the control NMP solvent swells using resin materials Isola E104 (low Tg) and Isola E117 (high Tg). The control NMP solvent swells were not applied to the Isola E104 resin and Circuposit® 4125 was not applied to the Isola E117 resin. The 100% bv diethylene glycol monobutyl ether was not tested for resin removal, but only for texturing as discussed below.

The resin materials were cut into coupons of about 7.5 cm x 7.5 cm and had a thickness of about 1.6 mm. Each resin coupon was dried in a conventional convection oven at about 105° C (about 220° F) for about an hour until a constant weight was achieved. Each coupon was weighed on a standard analytical balance. Each coupon was then treated with a solvent swell composition for about 15 minutes at about 85° C (185° F). Each treated resin coupon was then rinsed with water for about 4 minutes followed by etching for about 15 minutes at about 85° C to remove resin from the coupons. The etchant employed was Circuposit® 4130 an alkaline permanganate etching bath (obtainable from Shipley Company, Marlborough, MA, U.S.A.). After etching was completed, each coupon was rinsed with water for about 4 minutes followed by treating the coupons with a neutralizer to remove all permanganate residues from the coupons. The neutralizer employed was an aqueous solution of dilute sulfuric acid and hydrogen peroxide. All the coupons were then placed in the conventional convection oven at about 105° C over about 48 hours to dry. After drying, the bare laminate coupons were weighed using the standard analytical balance to determine the weight loss or resin loss from the coupons. The average weight loss for each solvent swell tested is recorded in the table below as loss of weight/surface area (mg/cm²).

The results showed that the solvent swells of the present invention did better than control solvent swells 1 and 2 in conditioning the Isola E 104 resin material for resin removal. Control solvent swell 1 had a weight loss of-0.30 mg/cm² and had a weight loss of -0.31 mg/cm². The solvent swells of the present invention had a low weight loss of-0.55 mg/cm² (10% bv ethylene glycol monophenyl ether and 20% bv NMP) and a high weight loss of -0.67 mg/cm² (40% bv ethylene glycol monophenyl ether and 20% bv NMP, and 40% bv ethylene glycol monophenyl ether and 40% bv NMP). Thus, the solvent swells of the present invention showed improved resin conditioning for resin removal over both control solvent swell 1 and control solvent swell 2 compositions for a low Tg resin material. Both the control 1 and control 2 were glycol containing solvent swells without heterocyclic nitrogen compounds.

The solvent swells of the present invention also showed improved conditioning for resin removal with high Tg resin material than control solvent swell 1 and most of the NMP and water solvent swells. Control solvent swell 1 had a weight loss of-0.29 mg/cm² and formulations containing 10% bv, 20% bv and 30% bv of NMP with the balance water had weight loss values below the weight loss values of the solvent swells of the present invention (see Table below). Although the 40% bv and 50% bv NMP solvent swells had weight loss values greater than three formulations of the present invention (see Runs 8, 10 and 12), overall the solvent swells of the present invention had improved weight loss over the control compositions.

Copper clad coupons of the above-identified resinous materials were employed to test the ability of the solvent swells of the present invention to condition resinous material for porous texturing with an etchant. The copper clad coupons were of the same dimensions as for the all resin coupons described above except that each copper clad coupon had from 10 to 15 through-holes. The diameter of the through-holes was about 1.0mm. Each copper clad coupon was treated with a solvent swell, etchant and neutralizer and rinsed according to the steps and conditions described above for the all resin coupons.

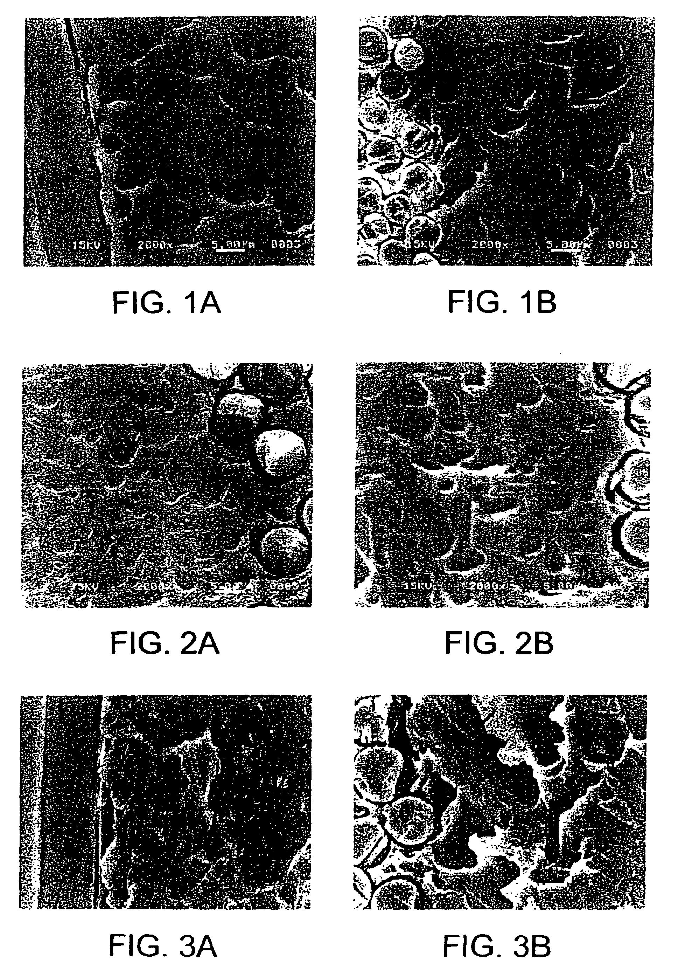

Each copper clad coupon was cut laterally such that the surface of one or more through-holes was examined for texturing. Examination was performed using a standard scanning electron microscope. Micrographs were taken of the sides of the treated through-holes using a camera attached to the electron microscope. Each micrograph was taken at about 2000X. The micrographs are disclosed in Figures 1A-B to 12A-D of the drawings.

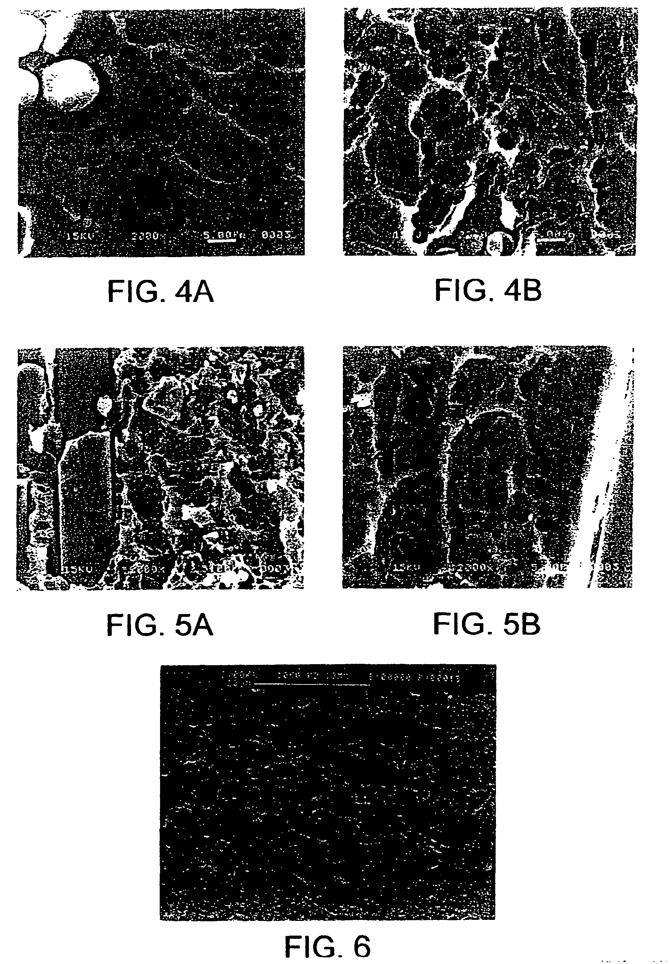

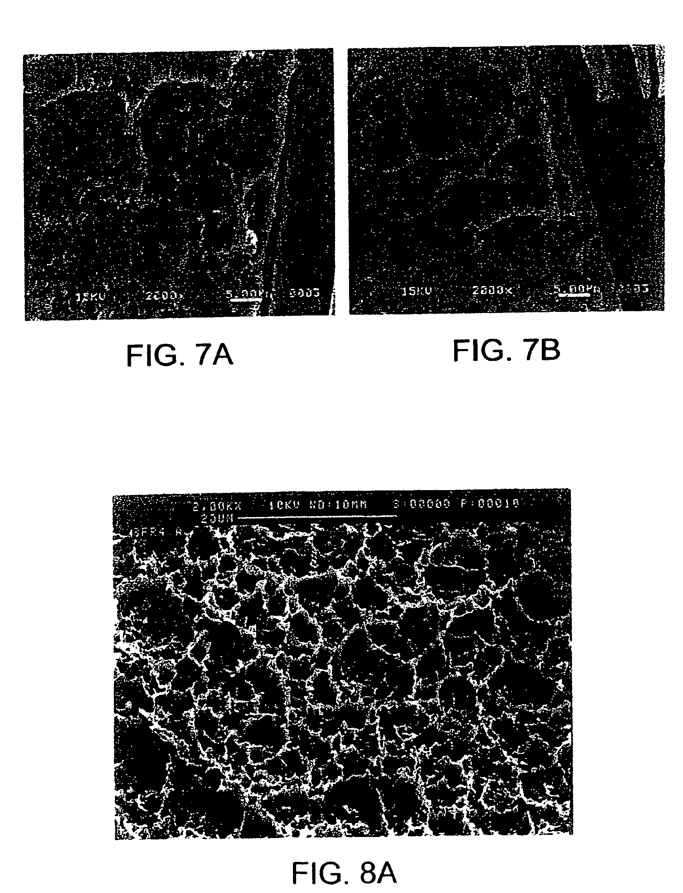

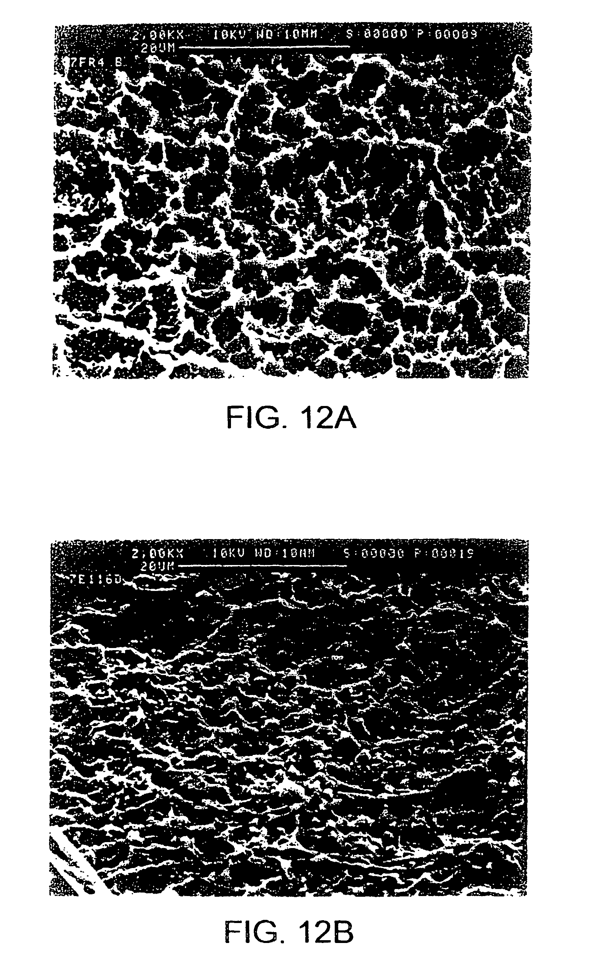

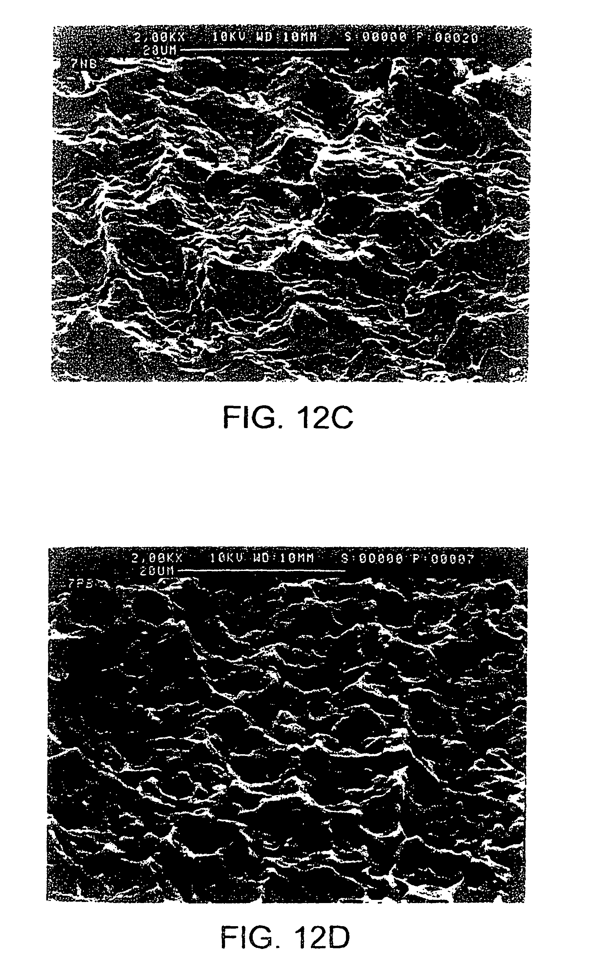

All of the coupons were observed for texturing and the quality of the texturing was recorded. Poor texturing was given a P, moderate texturing an M, and good texturing a G (see Table below). A poor textured resinous material had a smooth and/or shingled or shaled appearance under the electron microscope. Shingled or shaled appearance within the scope of the present invention means splintery or uneven overlapping layers (see Figs. 1A-B to Figs. 5A-B and Figs 7A-B). Poor texturing also includes a surface topography of small surface protrusions and sparse dispersion of holes or pin-holes (see Fig. 6). Moderate texturing showed some porosity (see Figs. 10C and 12C). Good texturing showed significant porosity (see Figs. 8A-C, 9A-D, 10A-B and 10D, 11A-11D, and 12A-B and 12D). Such porosity covered over at least about 60% of the solvent swell treated resinous material.

All of the solvent swells were used to condition a Isola E104 low Tg copper clad coupon except for the 100% diethylene glycol monobutyl ether composition. The texturing results were good in all of the coupons that were treated. Porous texturing was observed on all of the coupons. Figs. 8A (40% bv ethylene glycol monophenyl ether/40% bv NMP), 9A (10% bv ethylene glycol monophenyl ether/20% bv NMP), 10A (20% bv ethylene glycol monophenyl ether/20% bv NMP), 11A (20% bv ethylene glycol monophenyl ether/40% bv NMP), and 12A (40% bv ethylene glycol monophenyl ether/20% bv NMP) are micrographs of Isola E104 conditioned with solvent swells of the present invention. Porous texturing resulted from the conditioning of the solvent swells followed by etching. Micrographs of the control solvent swells are not shown.

Figs. 1A, 2A, 3A, 4A and 5A are micrographs of Isola E117 high Tg coupons treated with controls containing 10% bv NMP, 20% bv NMP, 30% bv NMP, 40% bv NMP and 50% bv NMP, respectively. Figs. 1B, 2B, 3B, 4B, and 5B are micrographs of Polyclad® 370 coupons treated with control compositions 10% bv NMP, 20% bv NMP, 30% bv NMP, 40% bv NMP and 50% bv NMP, respectively. All the NMP controls conditioned the coupons poorly. The etching process produced shingling type texturing. Such poor texturing was also produced with the control NMP solvent swells with the high Tg Nelco® 4000-6 coupons (micrographs not shown).

The 100% bv diethylene glycol monobutyl ether was also used to condition a Isola E117 coupon. The conditioning produced poor texturing results as shown in Fig. 6. The topography produced was small bumps and dispersed holes and pin-holes.

One copper clad Isola E117 high Tg coupon and one copper clad Polyclad® 370 high Tg coupon were treated with control solvent swell 1 and control solvent swell 2 both glycol ether solvent swell formulations. Figs. 1A-1B show micrographs of Isola E117 and Polyclad® 370 resinous material that were treated with standard solvent swell compositions of control solvent swell 1 and control solvent swell 2, respectively. The results were poor. The micrographs showed shingling or shaling and no porosity. Poor results were also obtained with copper clad Isola E117 and Polyclad® 370 coupons treated with solvent swell control compositions containing 10% bv N-methyl-2-pyrrolidone, 20% bv N-methyl-2-pyrrolidone, 30% bv N-methyl-2-pyrrolidone, 40% bv N-methyl-2-pyrrolidone, and 50% bv N-methyl-2-pyrrolidone. The micrographs (not included in the drawings) showed shingling of the resinous material. Poor texturing was also obtained from high Tg Nelco® 4000-6 copper clad coupons treated with the control solvent swell compositions (see Table below).

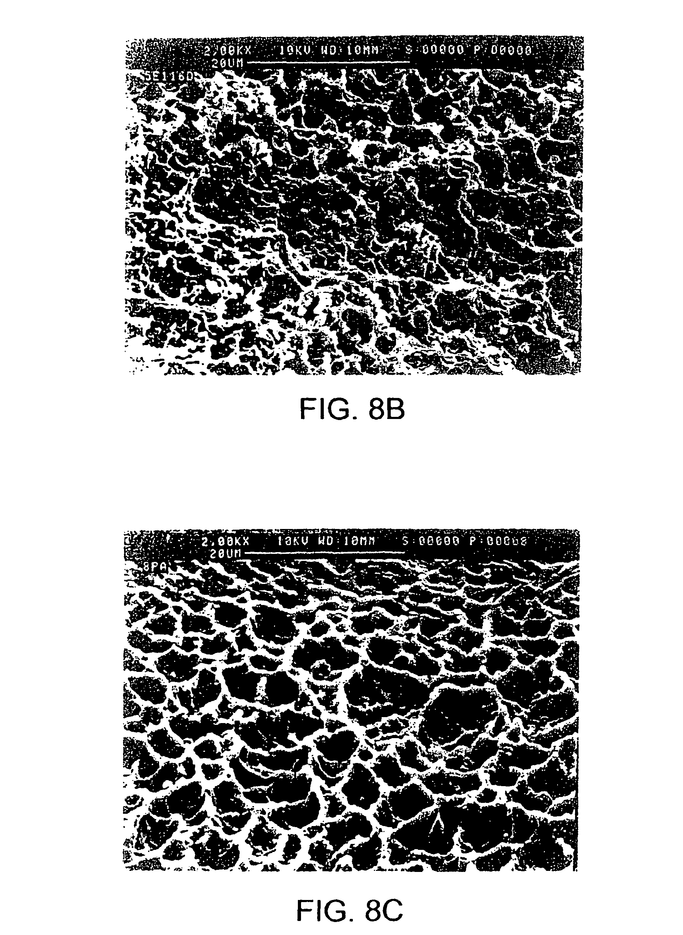

Figs. 8B and 8C show micrographs of a high Tg Isola E117 copper clad coupon (8B), and a high Tg Polyclad® 370 coupon (8C) that were treated with the solvent swell composition containing 40% bv ethylene glycol monophenyl ether/40% bv NMP/20% bv water. In the micrographs of Figs. 8B-8C, the texturing was good, i.e., porous. Although the porous topography differed from one material to the next, both coupons treated with the solvent swell composition of the present invention showed a highly porous surface.

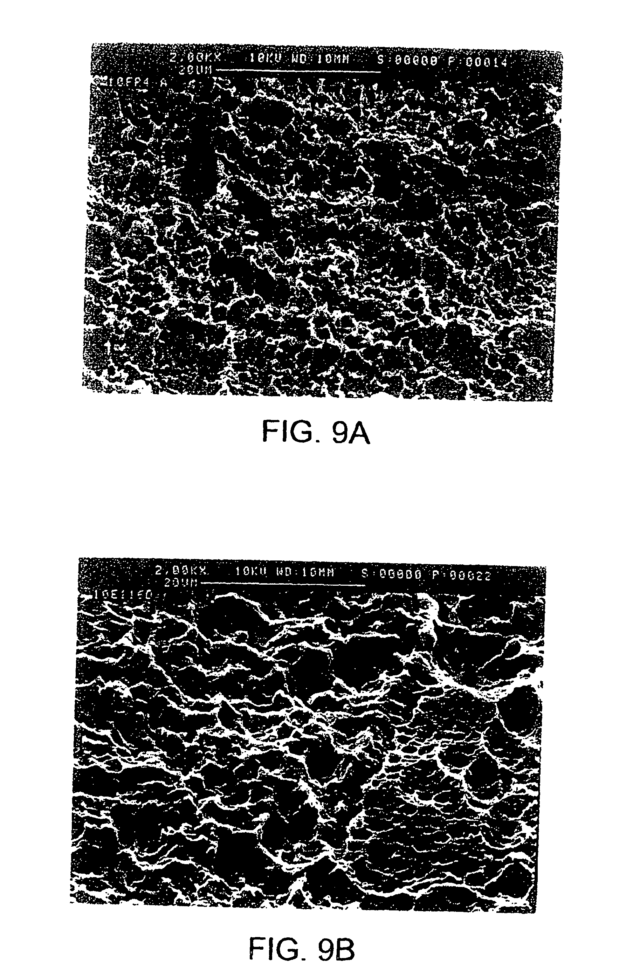

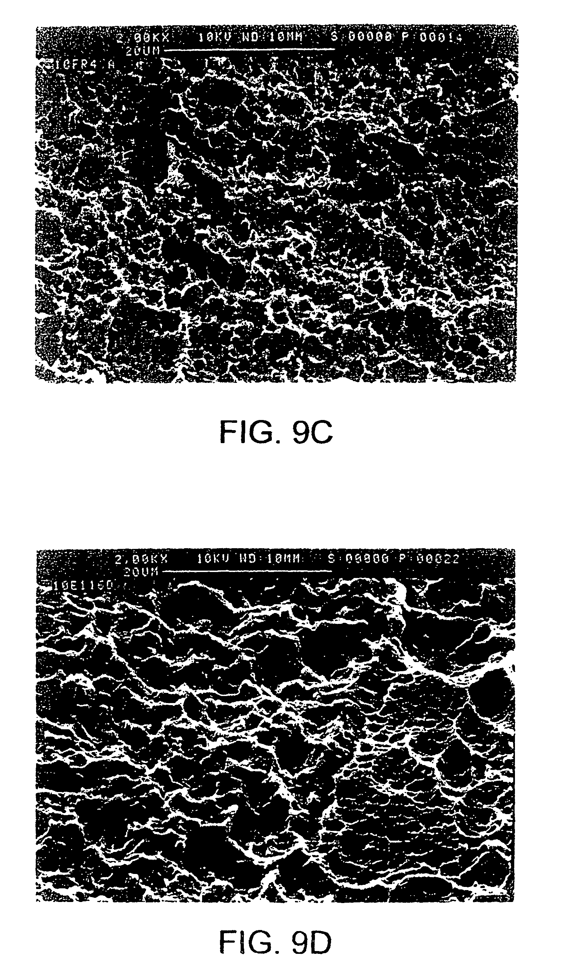

Figs. 9B to 9D show micrographs of Isola E117 (9B), Nelco® 4000-6 (9C), and Polyclad® 370 (9D) coupons treated with a solvent swell containing 10% bv ethylene glycol monophenyl ether/20% bv N-methyl-2-pyrrolidone/70% bv water. Good texturing was obtained on all three coupons. Figs. 9B to 9D show extensive porosity. The micrographs show deep pores within the surface of the coupons surrounded by high peaks and ridges. Such texturing provides good mechanical bonding with a deposited metal layer.

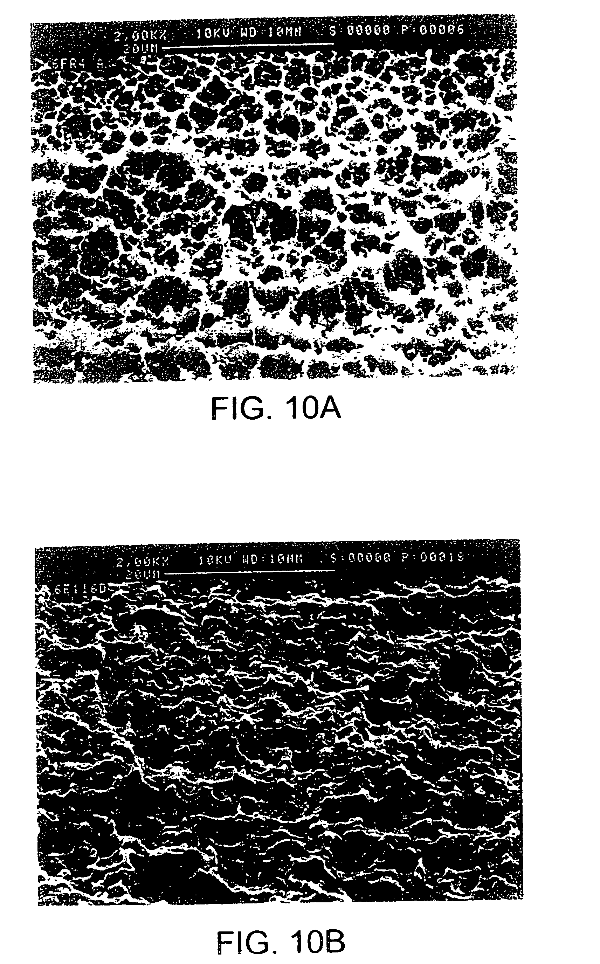

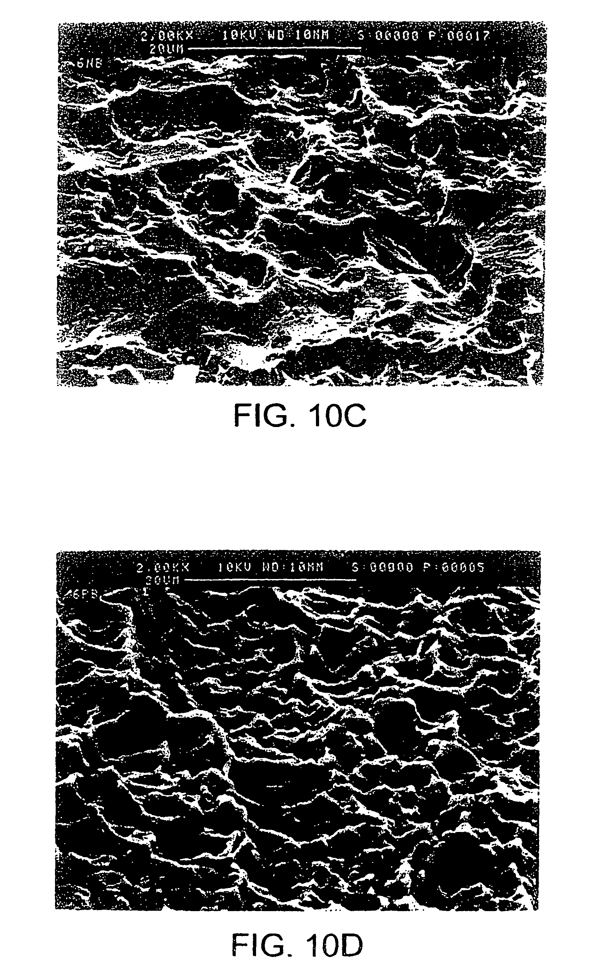

Figs. 10A to 10D show micrographs of Isola E117 coupon (10B), Nelco® 4000-6 coupon (10C), and Polyclad® 370 coupon (10D) treated with 20% bv ethylene glycol diphenyl ether/20% bv NMP/60% bv water. The solvent swell treatments conditioned each coupon such that upon etching good surface texture was produced on two of the coupons (Figs. 10B and 10D) with moderate texturing on the Nelco® 4000-6 coupon (10C). Figs. 10B and 10D show deep porous holes surrounded with high peaks and ridges to provide high integrity mechanical bonds with deposited metal. Although moderate texturing occurred on the Nelco® 4000-6 coupon, the coupon was sufficiently textured to provide a good mechanical bond with a deposited metal layer. Further, the texturing was still significantly better than on the coupons treated with the control compositions described above.

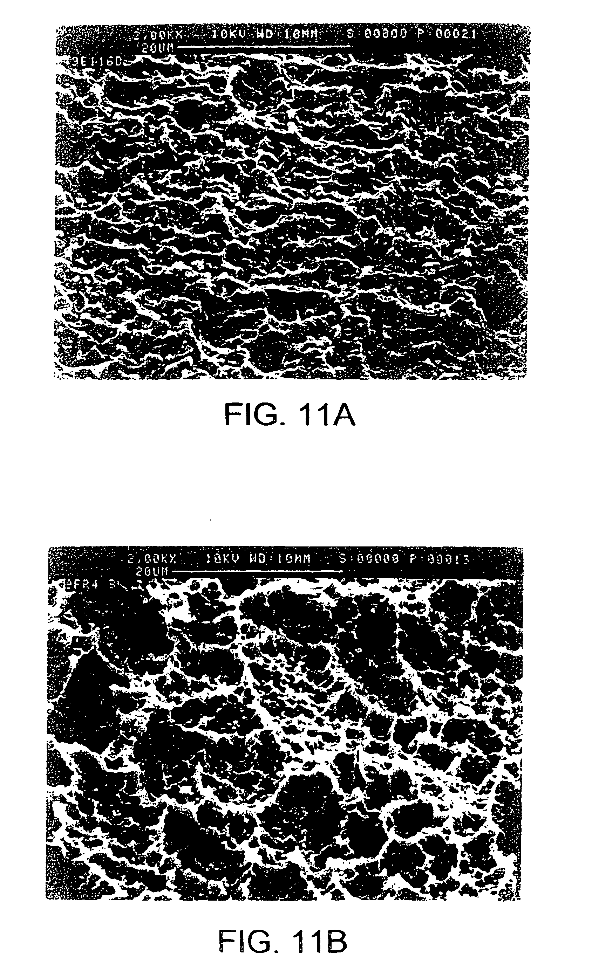

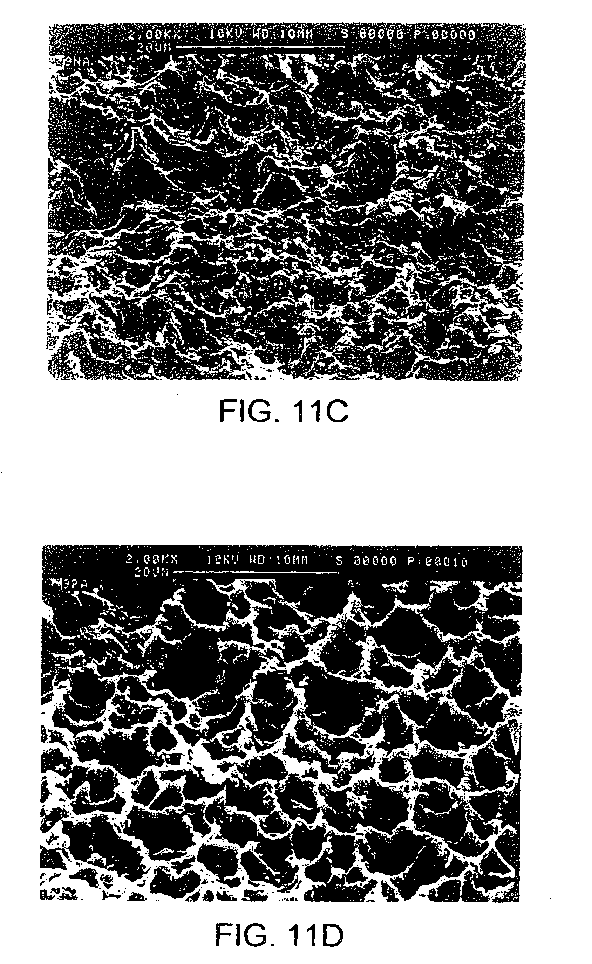

Figs.11 B, 11C and 11D show micrographs of a Isola E117 coupon (11B), a Nelco® 4000-6 coupon (11C), and a Polyclad® 370 coupon (11D) treated with 20% bv ethylene glycol monophenyl ether/40% bv NMP/40% bv water. As shown in the micrographs good texturing was obtained. Porous surfaces are apparent in all the micrographs.

Figs. 12B to 12D show micrographs of a Isola E117 (12B) coupon, a Nelco® 4000-6 coupon (12C), and a Polyclad® 370 (12D) treated with 40%bv ethylene glycol monophenyl ether/20% bv NMP/40% bv water. All the coupons had porous texturing. The solvent swell composition of the present invention conditioned the coupons such that highly porous surfaces were produced during etching. Figure 12C, which is the micrograph of the Nelco® 4000-6 coupon, showed moderate texturing. However, the texturing was still significantly better than the texturing of the controls.

The solvent swell compositions of the present invention showed good texturing or porous texturing on both high and low Tg resinous material in contrast to solvent swells containing glycol ethers without a heterocyclic nitrogen compound, and N-methyl-2-pyrrolidone solvent swells without a glycol ether. The deep pores and high peaks and ridges on the treated resinous surfaces provide a means by which deposited metal can form high integrity mechanical bonds with the resinous material. Such high integrity mechanical bonds prevent de-lamination, and prolong the life of electronic devices in which such laminated structures are employed.

**TABLE**

| Run# | Solvent Swell | Weight Loss (mg/cm²) of Isola E104 Resin, Tg 135°C | Texture of Isola E104 Resin, Tg 135° C | Weight Loss (mg/cm²) of Isola E117 Resin, Tg 170° C | Texture of Isola E117 Resin, Tg 170° C | Texuture of Polyclad® 370 Resin, Tg 175° C | Texture of Nelco® 4000-6 Resin, Tg 180° C |
|---|---|---|---|---|---|---|---|
| 1 | Solvent swell 1 | -0.30 | G | -0.29 | P | P | P |
| 2 | Solvent swell 2 | -0.31 | G | ------ | P | P | P |
| 3 | 10% NMP | ------ | G | -0.27 | P | P | P |
| 4 | 20% NMP | ------ | G | -0.28 | P | P | P |
| 5 | 30%NMP | ------ | G | -0.32 | P | P | P |
| 6 | 40% NMP | ----- | G | -0.56 | P | P | P |
| 7 | 50% NMP | ------ | G | -0.59 | P | P | P |
| 8 | 100% diethylene glycol monobutyl ether | ------ | ----- | ------ | p | ------ | ------ |
| 9 | 10% ethylene glycol monophenyl ether/20% NMP | -0.55 | G | -0.53 | G | G | G |
| 10 | 20% ethylene glycol monophenyl ether/20% NMP | -0.66 | G | -0.67 | G | G | M |
| 11 | 20% ethylene glycol monophenyl ether/40% NMP | -0.64 | G | -0.52 | G | G | G |
| 12 | 40% ethylene glycol monophenyl ether/20% NMP | -0.67 | G | -0.60 | G | G | M |
| 13 | 40% ethylene glycol monophenyl ether/40% NMP | -0.67 | G | -0.37 | G | G | G |

## Claims

1. A solvent swell composition comprising a heterocyclic nitrogen compound selected from a pyrrolidone, a pyrolidine or mixtures thereof in combination with one or more glycol phenyl ethers in sufficient amounts such that the solvent swell composition conditions a resinous material upon contacting the resinous material with the solvent swell composition such that etching the conditioned resinous material provides a porous texturing of the conditioned resinous material.

2. The solvent swell composition of claim 1, wherein the glycol phenyl ethers comprise ethylene glycol monophenyl ether, ethylene glycol diphenyl ether, propylene glycol monophenyl ether, propylene glycol diphenyl ether, diethylene glycol monophenyl ether, diethylene glycol diphenyl ether, dipropylene glycol monophenyl ether, dipropylene glycol diphenyl ether, or mixtures thereof.

3. The solvent swell composition of claim 1, further comprising a solvent with a flash point of at least 100°C.

4. The solvent swell composition of claim 1, wherein the pyrolidone is N-methyl-2-pyrrolidone, 2-pymolidone, N-ethyl-2-pyrrolidone, M-cyclohexyl-2-pyrrolidone. N-dodecyl-2-pyrrolidone, N-(2-hydroxyethyl)-2-pyrrolidone, 1,5-dimethyl-2-pyrrolidone, 3,3-dimethyl-2-pyrrolidone or mixtures thereof.

5. The solvent swell composition of claim 1 wherein the pyrolidine is pyrrolidine, 1,2-dimethyl pyrrolidine, 2,5-dimethyl pyrrolidine or mixtures thereof.

6. A method of treating a resinous material comprising contacting the resinous material with a solvent swell composition comprising a heterocyclic nitrogen compound selected from a pyrrolidone, a pyrollidine or mixtures thereof in combination with one or more glycol phenyl ethers in sufficient amounts to condition the resinous material for porous texturing with an etchant; and contacting the conditioned resinous material with an etchant to porously texturize the conditioned resinous material.

7. The method of claim 6, wherein the resinous material is disposed on a printed wiring board, or an inner layer thereof.

8. The method of claim 6. further comprising the step of contacting the porous texture of the resinous material with an activator for making the resinous material electrically conductive such that the activator is dispersed within pores and on a surface of the resinous material.

9. The method of claim 6, wherein a dwell time for the solvent swell composition on the resinous material is from 30 second to 30 minutes.

10. A solvent swell composition of claim 1 comprising form 20% to 40% bv of a pyrrolidone. In combination with from 10% bv to 40% of one or more glycol phenyl ethers with the balance water and/or a solvent having a flash point of at least 100°C.

## Patentansprüche

1. Lösungsmittelquellzusammensetzung, umfassend eine heterocyclische Stickstoffverbindung, ausgewählt aus einem Pyrrolidon, einem Pyrrolidin oder Gemischen davon, in Kombination mit einem oder mehreren Glycolphenylethern in ausreichenden Mengen, so dass die Lösungsmittelquellzusammensetzung ein harzartiges Material durch bzw. nach Inkontaktbringen des harzartigen Materials mit der Lösungsmittelquellzusammensetzung derart konditioniert, dass das Ätzen des konditionierten harzartigen Materials eine poröse Texturierung des konditionierten harzartigen Materials bereitstellt.

2. Lösungsmittelquellzusammensetzung nach Anspruch 1, wobei die Glycolphenylether Ethylenglycolmonophenylether, Ethylenglycoldiphenylether, Propylenglycolmonophenylether, Propylenglycoldiphenylether, Diethylenglycolmonophenylether, Diethylenglycoldiphenylether, Dipropylenglycolmonophenylether, Dipropylenglycoldiphenylether oder Gemische davon umfassen.

3. Lösungsmittelquellzusammensetzung nach Anspruch 1, welche weiter ein Lösungsmittel mit einem Flammpunkt von mindestens 100°C umfasst.

4. Lösungsmittelquellzusammensetzung nach Anspruch 1, wobei das Pyrrolidon N-Methyl-2-pyrrolidon, 2-Pyrrolidon, N-Ethyl-2-pyrrolidon, N-Cyclohexyl-2-pyrrolidon, N-Dodecyl-2-pyrrolidon, N-(2-Hydroxyethyl)-2-pyrrolidon, 1,5-Dimethyl-2-pyrrolidon, 3,3-Dimethyl-2-pyrrolidon oder Gemische davon ist.

5. Lösungsmittelquellzusammensetzung nach Anspruch 1, wobei das Pyrrolidin Pyrrolidin, 1,2-Dimethylpyrrolidin, 2,5-Dimethylpyrrolidin oder Gemische davon ist.

6. Verfahren zur Behandlung eines harzartigen Materials, umfassend das Inkontaktbringen des harzartigen Materials mit einer Lösungsmittelquellzusammensetzung, welche eine heterocyclische Stickstoffverbindung, ausgewählt aus einem Pyrrolidon, einem Pyrrolidin oder Gemischen davon, in Kombination mit einem oder mehreren Glycolphenylethern in ausreichenden Mengen umfasst, um das harzartige Material zur porösen Texturierung mit einem Ätzmittel zu konditionieren; und das Inkontaktbringen des konditionierten harzartigen Materials mit einem Ätzmittel, um das konditionierte harzartige Material porös zu texturieren.

7. Verfahren nach Anspruch 6, wobei das harzartige Material auf eine gedruckte Verdrahtungsplatte bzw. Leiterplatte oder eine innere Schicht davon angeordnet bzw. aufgebracht wird.

8. Verfahren nach Anspruch 6, ferner umfassend den Schritt des Inkontaktbringens der porösen Textur des harzartigen Materials mit einem Aktivierungsmittel, um das harzartige Material elektrisch leitfähig zu machen, derart, dass das Aktivierungsmittel in Poren und auf einer Oberfläche des harzartigen Materials verteilt ist/wird.

9. Verfahren nach Anspruch 6, wobei eine Verweilzeit für die Lösungsmittelquellzusammensetzung auf dem harzartigen Material zwischen 30 Sekunden und 30 Minuten beträgt.

10. Lösungsmittelquellzusammensetzung nach Anspruch 1, welche von 20 bis 40 Volumenprozent eines Pyrrolidons in Kombination mit von 10 bis 40 Volumenprozent eines oder mehrerer Glycolphenylether(s), umfasst, wobei der Rest Wasser und/oder ein Lösungsmittel mit einem Flammpunkt von mindestens 100°C ist/sind.

## Revendications

1. Composition de gonflement par solvant comprenant un composé azoté hétérocyclique choisi parmi une pyrrolidone, une pyrrolidine ou des mélanges de celles-ci en combinaison avec un ou plusieurs glycol phényl éthers en des quantités suffisantes de telle sorte que la composition de gonflement par solvant conditionne un matériau résineux lors de la mise en contact du matériau résineux avec la composition de gonflement par solvant de telle sorte que le gravage du matériau résineux conditionné fournisse une texturation poreuse du matériau résineux conditionné.

2. Composition de gonflement par solvant selon la revendication 1, dans laquelle les glycol phényl éthers comprennent l'éthylène glycol monophényl éther, l'éthylène glycol diphényl éther, le polypropylène glycol monophényl éther, le polypropylène glycol diphényl éther, le diéthylène glycol monophényl éther, le diéthylène glycol diphényl éther, le dipropylène glycol monophényl éther, le dipropylène glycol diphényl éther ou les mélanges de ceux-ci.

3. Composition de gonflement par solvant selon la revendication 1, comprenant en outre un solvant ayant un point éclair d'au moins 100 °C.

4. Composition de gonflement par solvant selon la revendication 1, dans laquelle la pyrrolidone est la N-méthyl-2-pyrrolidone, la 2-pyrrolidone, la N-éthyl-2-pyrrolidone, la N-cyclohexyl-2-pyrrolidone, la N-dodécyl-2-pyrrolidone, la N-(2-hydroyéthyl)-2-pyrrolidone, la 1,5-diméthyl-2-pyrrolidone, la 3,3-diméthyl-2-pyrrolidone ou les mélanges de celles-ci.

5. Composition de gonflement par solvant selon la revendication 1, dans laquelle la pyrrolidine est la pyrrolidine, la 1,2-diméthyl pyrrolidine, la 2,5-diméthyl pyrrolidine ou les mélanges de celles-ci.

6. Procédé de traitement d'un matériau résineux comprenant la mise au contact du matériau résineux avec une composition de gonflement par solvant comprenant un composé azoté hétérocyclique choisi parmi une pyrrolidone, une pyrrolidine ou les mélanges de celles-ci en combinaison avec un ou plusieurs glycol phényl éthers en des quantités suffisantes pour conditionner le matériau résineux pour une texturation poreuse avec un agent de gravage ; et la mise au contact du matériau résineux conditionné avec un agent de gravage pour texturer de manière poreuse le matériau résineux conditionné.

7. Procédé selon la revendication 6, dans lequel le matériau résineux est disposé sur une carte de circuit imprimé ou sur une couche interne de celle-ci.

8. Procédé selon la revendication 6, comprenant en outre l'étape consistant à mettre en contact la texture poreuse du matériau résineux avec un activateur pour rendre le matériau résineux électriquement conducteur de telle sorte que l'activateur est dispersé au sein de pores et sur une surface du matériau résineux.

9. Procédé selon la revendication 6, dans lequel un temps de maintien pour la composition de gonflement par solvant sur le matériau résineux est de 30 secondes à 30 minutes.

10. Composition de gonflement par solvant selon la revendication 1, comprenant de 20 % à 40 % en volume d'une pyrrolidone en combinaison de 10 % à 40 % en volume d'un ou plusieurs glycol phényl éthers, le reste étant de l'eau et/ou un solvant ayant un point éclair d'au moins 100 °C.
